# EUROPÄISCHE PATENTSCHRIFT

(11) **EP 2 862 958 B1**
(45) Veröffentlichungstag und Bekanntmachung des Hinweises auf die Patenterteilung: **05.09.2018**
(21) Anmeldenummer: 14184947.1
(22) Anmeldetag: 16.09.2014
(51) Int. Cl.: C23C 28/04, C23C 14/00, C23C 14/02, C23C 14/06, C23C 28/00, F02F 3/00, F02F 3/10, F02F 3/12, F02F 3/14, B23P 15/10

(54) **Stahlkolben für eine Brennkraftmaschine und Verfahren zu dessen Herstellung**
Steel piston for an internal combustion engine and method for producing the same
Piston en acier pour un moteur à combustion et son procédé de fabrication

(30) Priorität: 17.10.2013 DE 102013221102
(43) Veröffentlichungstag der Anmeldung: 22.04.2015
(73) Patentinhaber: Oerlikon Surface Solutions AG, Pfäffikon, 8808 Pfäffikon SZ (CH)
(72) Erfinder: Dr. Lehnert, Monika, 71686 Remseck (DE); Dr. Rose, Reinhard, 70736 Fellbach (DE); Ramm, Jürgen, 7304 Maienfeld (CH); Widrig, Beno, 7310 Bad Ragaz (CH)
(74) Vertreter: BRP Renaud & Partner mbB Rechtsanwälte Patentanwälte Steuerberater

(56) Entgegenhaltungen:
- WO-A1-88/08926
- WO-A1-93/13245
- WO-A1-2005/121403
- WO-A1-2008/043606
- WO-A1-2010/102930
- DE-A1- 3 134 768
- DE-A1- 10 108 834
- GB-A- 629 235
- US-A1- 2005 214 540

## Beschreibung

Die vorliegende Erfindung betrifft einen Stahlkolben für eine Brennkraftmaschine, insbesondere einen Stahlkolben für eine Brennkraftmaschine, der einen Kolbenboden und eine auf dem Kolbenboden aufgebrachte Schutzschicht aufweist. Die Erfindung betrifft außerdem ein Verfahren zur Herstellung eines solchen Stahlkolbens.

Bei Stahlkolben für eine Brennkraftmaschine, insbesondere für Dieselmotoren, tritt das Problem auf, dass die nach dem Einspritzen entzündete, brennende Kraftstoffwolke eine sehr große Wärmemenge erzeugt. Die Brennraummulde, die im Boden des Stahlkolbens ausgebildet ist, unterliegt dadurch typischerweise in Bereichen nahe an und/oder auf der Oberkante der Brennraummulde, d.h. dem lippenartigen Grenzbereich zwischen der Brennraummulde und dem flachen oberen Rand des Kolbenbodens, d.h. dem Muldenrand, einer starken Oxidation. Bei dieser Oxidation wird das Eisen in dem Stahl bis zu Fe₂O₃ oxidiert und die resultierenden Oxide weisen keine Haftung an dem darunter liegenden, nicht oxidierten Stahlmaterial des Kolbens auf.

Durch mechanische Ausdehnungs-/Kontraktionsprozesse wird die gebildete oxidierte Schicht schließlich abgelöst, wobei sogenannte Zunderkerben gebildet werden. Durch diesen Vorgang werden die dadurch erodierten Bereiche im Laufe der Zeit so groß, dass sie mit dem bloßen Auge sichtbar sind. Durch weitere Ausbreitung dieser Zunderkerben bis in das Grundmaterial des Stahlkolbens können schließlich Muldenrandrisse auftreten, die im Extremfall zu einer Zerstörung des Kolbens führen können. Ferner tritt aufgrund der Zunderkerben das Problem auf, dass durch die entsprechende Veränderung der Gestalt des Muldenrands Störungen des Verbrennungsprozesses verursacht werden und dadurch das Abgasverhalten des Motors verschlechtert wird.

Im Hinblick auf das vorstehend beschriebene Problem ist beispielsweise aus der US 7,458,358 B2 ein Verfahren bekannt, bei dem auf den Kolbenboden eines Kolbens für eine Brennkraftmaschine ein Beschichtungsmaterial aufgebracht wird, das eine Mikrostruktur und eine Porosität aufweist, wobei die Beschichtung mit einem hochenergetischen Laserstrahl bestrahlt wird, um die Dichte der Beschichtung zu erhöhen, während gleichzeitig die Mikrostruktur umgewandelt wird und eine Materialbindung zwischen der Beschichtung und der Kolbenbodenoberfläche erzeugt wird, und ein Teil der Beschichtung maskiert wird, um eine Bestrahlung mit dem Laserstrahl zu verhindern.

Aus der EP 1 217 095 A1 ist eine Schutzbeschichtung für ein thermisch belastetes Bauteil, insbesondere ein Turbinenbauteil, zum Schutz vor Korrosion und/oder Oxidation und/oder Erosion bekannt, wobei die Schutzbeschichtung eine einschichtige oder mehrschichtige Versiegelungsbeschichtung aus einem amorphen Werkstoff aufweist.

Ferner ist aus der DE 197 41 800 A1 ein Schichtsystem zur Beschichtung korrosionsanfälliger Metallsubstrate mit wenigstens einer Zwischenschicht und wenigstens einer Funktionsschicht bekannt, wobei die Funktionsschicht ein Nitrid, Carbonitrid und/oder Oxynitrid mindestens eines der Metalle aus der 4. bis 6. Nebengruppe des Periodensystems ist und die Zwischenschicht aus einem oder mehreren Metalloxid(en) aufgebaut ist. Aus dem Patent GB 629 235 A ist eine Hartverchromung von Böden von Stahlkolben für Dieselmotoren bekannt. Die Chromschicht ist porös und korrosions- und abnutzungsbeständig.

Mit den Beschichtungen und Verfahren des Standes der Technik kann jedoch die vorstehend genannte Zunderkerbenbildung und die damit einhergehende Schädigung des Kolbens nicht vollständig zufriedenstellend verhindert werden.

Die vorliegende Erfindung beschäftigt sich deshalb mit dem Problem, einen Stahlkolben einer Brennkraftmaschine im Hinblick auf das vorstehend genannte Problem weiter zu verbessern.

Dieses Problem wird erfindungsgemäß durch die Gegenstände der unabhängigen Ansprüche gelöst. Vorteilhafte Ausführungsformen sind Gegenstand der abhängigen Ansprüche.

Die vorliegende Erfindung beruht auf dem allgemeinen Gedanken, auf den Kolbenboden eines Stahlkolbens eine Schutzschicht aufzubringen, die eine Haftschicht und darauf aufgebracht eine Funktionsschicht enthält, wobei die Funktionsschicht eine Mehrzahl von spezifischen Schichten aus Metallnitriden, -oxiden bzw. -oxynitriden enthält. Die Erfindung ist in den Ansprüchen 1, 3 und 12 definiert. Bevorzugte Ausführungsformen sind in den Ansprüchen 2, 4 bis 11 und 13 beansprucht. Erfindungsgemäß enthält die Schutzschicht a) eine Haftschicht aus Cr oder CrN, die auf der Oberfläche des Kolbenbodens vorliegt, und b) eine Funktionsschicht, die auf der Haftschicht vorliegt, wobei die Funktionsschicht gegebenenfalls eine oder mehrere Schicht(en) (A) aus CrN sowie eine oder mehrere Schicht(en) (B) aus CrON in der Form von [(A)/(B)]ₐ aufweist, wobei a = 1 bis 100 ist. In einer Alternative kann die Funktionsschicht auch nur eine CrON-Schicht aufweisen, d.h., a = 1 und (A) liegt nicht vor.

Das Schichtsystem gemäß der Erfindung verhindert Verzunderungen der Kolbenböden in gegenwärtigen Brennkraftmaschinen. Das Schichtsystem hat den wirtschaftlichen und prozesstechnischen Vorteil, dass für die Beschichtung lediglich Verdampfungsquellen, die mit Cr-Targets bestückt sind, benötigt werden. Das trägt zu einem höheren Durchsatz im Beschichtungsverfahren bei und damit zu niedrigeren Produktionskosten. In einer nicht erfindungsgemäßen Ausführungsform enthält die Funktionsschicht gegebenenfalls eine oder mehrere Schicht(en) (C) aus AlCrO sowie eine oder mehrere Schichten (C') aus AlCrO welche sich von (C) unterscheidet in der Form [(C)/(C')]ₐ auf, wobei a = 1 bis 100 ist. In einer speziellen Abwandlung dieser Ausführungsform kann die Funktionsschicht auch nur eine AlCrO-Schicht aufweisen, d.h. a = 1 und (C) liegt nicht vor.

Das Schichtmaterial AlCrO, das gemäß der nicht erfindugsgemäßen Ausführungsform verwendet wird, kann bekanntlich als Mischkristall in Korundstruktur hergestellt werden, wie es in WO 08/043606 A1 beschrieben ist, und weist zusätzlich zur Wirkung als Oxidationsbarriere ferner eine höhere thermische Stabilität im Vergleich zum CrON-Schichtsystem gemäß der erfindungsgemäßen Ausführungsform auf. Dies zeigt sich vor allem darin, dass sich die Kristallstruktur der AlCrO-Schicht auch bei Temperaturen bis 1000 °C nicht ändert, d.h. es kommt auch zu keinen wesentlichen Dichteänderungen und demzufolge zu keinen mechanischen Instabilitäten der Schicht. Das Schichtsystem gemäß der nicht erfindungsgemäßen Ausführungsform bietet deshalb einen Lösungsansatz, falls die Kolbenböden zukünftig noch höheren Brennraumtemperaturen ausgesetzt werden sollen.

Bei jeder Ausführungsform der Schichtsysteme können die Übergänge zwischen der Haftschicht und der Funktionsschicht sowohl abrupt wie auch fließend in Bezug auf den Metallgehalt wie auf den Stickstoff- und Sauerstoffgehalt gestaltet werden.

Es wurde erfindungsgemäß gefunden, dass mit der oben genannten spezifischen Kombination von Schichten eine thermische Oxidation und damit eine Zunderkerbenbildung wirkungsvoll verhindert werden kann. Dies wird durch die Einwirkung von Wärme in Gegenwart von Sauerstoff auf die zunächst offenporige Funktionsschicht erreicht, die sich dadurch in eine geschlossenporige Schicht umwandelt. Dadurch kann eine Oxidation des Stahlbasismaterials des Kolbens nicht mehr stattfinden.

Bei einer vorteilhaften Weiterbildung der erfindungsgemäßen Lösung sowie der nicht erfindungsgemäßen Ausführungsform ist a = 1, d.h. die Funktionsschicht besteht aus einer Schicht (A) und einer Schicht (B) bzw. einer Schicht (C) und einer Schicht (C'), so dass ein Aufbau der Schutzschicht entsteht, der als Haftschicht/Schicht (A)/Schicht (B) bzw. Haftschicht/Schicht (C)/Schicht (C') dargestellt werden kann. Dabei wird für die Haftschicht in beiden Ausführungsformen Cr oder CrN eingesetzt, vorzugsweise CrN.

Gemäß einer weiteren vorteilhaften Weiterbildung der erfindungsgemäßen Lösung liegt in dem Fall, bei dem a = 1 ist, die Schicht (B) bzw. (C') als Gradientenschicht mit zunehmendem Sauerstoffanteil in der Richtung der Oberfläche vor, die der Schicht (A) abgewandt ist bzw. (in dem Fall der nicht erfindungsgemäßen Ausführungsform) die der Haftschicht abgewandt ist. Dies hat gegenüber einer Schicht (B) bzw. (C'), deren Sauerstoffgehalt über die gesamte Dicke der Schicht konstant ist, den Vorteil, dass sich die mechanischen Eigenschaften der Oxidschicht (B) bzw. (C') vorteilhafter an die Schicht (A) bzw. (in dem Fall der nicht erfindungsgemäßen Ausführungsform) an die Haftschicht anpassen lassen.

Die Erhöhung des Sauerstoffanteils mit zunehmender Schichtdicke der Schicht (B) bzw. (C') kann in an sich bekannter Weise durch sukzessives Erhöhen des Sauerstoffanteils beim Abscheiden der Schicht (B) bzw. (C') erreicht werden. Bezüglich des Verfahrens zum Abscheiden der Schutzschicht wird auf die Beschreibung des erfindungsgemäßen Verfahrens verwiesen.

Gemäß einer weiteren vorteilhaften Weiterbildung der erfindungsgemäßen Lösung ist a = 2 bis 50, vorzugsweise 10 bis 40, insbesondere 15 bis 30. Die jeweilige Abscheidung einer Mehrzahl von Schichten (A) und (B) bzw. (C) und (C') gegenüber der Abscheidung von nur jeweils einer Schicht (A) bzw. (B) bzw. (C) und (C') hat den Vorteil, dass damit intrinsische Schichtspannungen gezielt kontrolliert werden können und die Haftung des Schichtsystems auf der Kolbenoberfläche für die thermische Wechselbelastung optimiert werden kann.

Zweckmäßig weist die Schutzschicht eine Dicke von 1 µm bis 15 µm, vorzugsweise von 2 µm bis 12 µm, noch mehr bevorzugt von 4 µm bis 10 µm und insbesondere von 5 µm bis 8 µm auf. Wenn die Dicke der Schutzschicht unter 1 µm beträgt, kann die erfindungsgemäße Oxidationsschutzwirkung gegebenenfalls nicht in ausreichender Weise erhalten werden. Der Grund hierfür liegt darin, dass es bei dem aus wirtschaftlichen Gründen bevorzugten Verfahren der reaktiven kathodischen Funkenverdampfung (PVD) zu Spritzern kommen kann, die bei zu dünnen Schichten nicht ausreichend in die Schicht eingebaut werden können. Ein Ausweichen auf andere Verfahren wie gefilterte kathodische Funkenverdampfung oder Sputtern würde eventuell kleinere Schichtdicken zulassen, hätte aber höhere Produktionskosten zur Folge, was dem Fachmann bekannt ist. Wenn die Dicke der Schutzschicht andererseits mehr als 15 µm beträgt, verliert diese zunehmend ihre Fähigkeit, sich den temperaturbedingten Formänderungen des Substrates anzupassen. Sie wird spröder und es kann gegebenenfalls zu einem Ablösen der Schutzschicht kommen.

Gemäß einer weiteren vorteilhaften Weiterbildung der erfindungsgemäßen Lösung weist die Haftschicht eine Dicke von 0,1 µm bis 5 µm, vorzugsweise von 1 µm bis 5 µm und insbesondere von 1,5 µm bis 4,0 µm auf. Die untere Grenze der Haftschichtdicke wird vor allem dadurch bestimmt, dass auch die geometrisch schlechter zugänglichen Kolbenbodenflächen eine zusammenhängende Haftschicht aufweisen sollten. Haftschichtdicken von mehr als 5 µm tragen erfahrungsgemäß zu keiner weiteren Verbesserung der Haftung der Schutzschicht bei, verschlechtern jedoch die Wirtschaftlichkeit des Beschichtungsverfahrens.

Zweckmäßig weist die Funktionsschicht eine Dicke von 0,5 µm bis 10 µm, vorzugsweise von 1 µm bis 8 µm, mehr bevorzugt von 2 µm bis 5 µm und insbesondere von 3 µm bis 4 µm auf. Dabei können die Schichten (A) und (B) bzw. (C) und (C') der Funktionsschicht unabhängig jeweils eine Dicke von 0,04 µm bis 0,25 µm aufweisen. Gemäß einer bevorzugten Ausführungsform der vorliegenden Erfindung weisen die Schichten (A) und (B) bzw. (C) und (C') der Funktionsschicht jeweils die gleiche Dicke auf.

Gemäß einer weiteren vorteilhaften Weiterbildung der erfindungsgemäßen Lösung liegt die Schutzschicht nur auf dem Muldenrand des Kolbenbodens vor. Da die Bildung von Zunderkerben insbesondere im Bereich des Muldenrands auftritt, kann ein entsprechend wirksamer Schutz des Kolbens gemäß der vorliegenden Weiterbildung besonders wirtschaftlich erreicht werden.

Die vorliegende Erfindung stellt ferner ein Verfahren zur Herstellung eines Stahlkolbens für eine Brennkraftmaschine gemäß der vorstehenden Beschreibung bereit, das die Schritte aufweist: Bereitstellen eines Stahlkolbens, der einen Kolbenboden aufweist, und Aufbringen einer Schutzschicht, wie sie vorstehend definiert ist, auf den Kolbenboden, insbesondere nur auf den Muldenrand des Kolbenbodens, mittels eines PVD-Verfahrens.

Als Stahlkolben, der mit dem erfindungsgemäßen Verfahren beschichtet werden soll, kann zweckmäßig jedweder Stahlkolben für eine Brennkraftmaschine verwendet werden, der dem Fachmann bekannt ist, vorzugsweise ein Stahlkolben für einen Dieselmotor.

Insbesondere wird als zu beschichtender Stahlkolben ein Stahlkolben verwendet, der im NKW-Bereich (Heavy Duty, Medium Duty) bzw. im PKW-Dieselbereich (HSD = High Speed Diesel) eingesetzt wird. Die typischen PKW-Kolbendurchmesser liegen im Bereich 75 bis 90 mm, während im MD-/HD-Bereich Durchmesser zwischen 105 mm und etwa 160 mm zum Einsatz kommen. Die verwendeten Grundwerkstoffe kommen aus dem Bereich der AFP-Eisenwerkstoffe, z.B. 39MnVS6, oder anderer, höher temperaturbeständiger Stähle, wie z.B. 42CrMo4. Die Ausbildung der Kolbenmulde kann relativ einfach sein mit einem definierten Radius und anschließendem - je nach Kolbentyp bzw. vorhandenen thermodynamischen Randbedingungen - Hinterschnitt. Unter Umständen kann diese Mulde auch als Stufenmulde ausgebildet sein. Bevorzugte Ausführungsbeispiele der Erfindung sind in den Zeichnungen dargestellt und werden in der nachfolgenden Beschreibung näher erläutert.

Dabei zeigen, jeweils schematisch,
- Fig. 1: eine gemäß Beispiel 1 aufgebrachte Beschichtung im Abscheidungszustand,
- Fig. 2: ein mikroskopisches Schliffbild einer Schnittfläche durch einen erfindungsgemäß beschichteten Stahlkolben nach dem Motortest im Bereich des Muldenrands gemäß Beispiel 1,
- Fig. 3: ein mikroskopisches Schliffbild einer Schnittfläche durch einen unbeschichteten Stahlkolben nach dem Motortest im Bereich des Muldenrands gemäß dem Vergleichsbeispiel,
- Fig. 4: eine Schutzschicht gemäß der erfindungsgemäßen Ausführungsform auf einem polierten Hartmetallsubstrat bei einer Vergrößerung von 25000x, und
- Fig. 5: eine Schutzschicht gemäß der nicht erfindungsgemäßen Ausführungsform auf einem polierten Hartmetallsubstrat bei einer Vergrößerung von 50000x.

Im Folgenden wird ein Beispiel für das Aufbringen der erfindungsgemäßen Schutzschicht auf einen Kolbenboden mittels eines bekannten PVD-Verfahrens detailliert beschrieben.

Als Beispiel für ein PVD-Verfahren wird nachstehend ein Beschichtungsprozess beschrieben, der auf der reaktiven kathodischen Funkenverdampfung beruht. Dies soll aber nicht als Einschränkung auf allein dieses PVD-Verfahren verstanden werden. Auch andere PVD-Verfahren wie beispielsweise Sputtern, Elektronenstrahlverdampfen oder Laserablation können zur Beschichtung benutzt werden, die jedoch eine geringere Wirtschaftlichkeit aufweisen und einen größeren technischen Aufwand bei der Kontrolle des Beschichtungsprozesses erfordern.

Zu Beginn werden die zu beschichteten Substrate (Kolben) in die dafür vorgesehenen drehbaren Halterungen einer Vakuumbeschichtungsanlage eingebracht. Anschließend wird die Vakuumbeschichtungsanlage auf einen Druck von etwa 10⁻⁴ mbar abgepumpt.

Zur Einstellung der Prozesstemperatur wird ein durch Strahlungsheizungen unterstütztes Niedervoltbogenplasma (NVB) zwischen einer Heißkathode und den anodisch geschalteten Werkstücken in einer Argon-Wasserstoffatmosphäre gezündet.

Bei diesem Prozess wurden folgende Parameter eingestellt:

| | |
|---|---|
| Entladestrom NVB | 110 A |
| Argonfluss | 50 sccm |
| Wasserstofffluss | 300 sccm |

Unter diesen Bedingungen stellt sich ein Prozessdruck von 1,4 x 10⁻² mbar ein. Die Heizeinrichtungen und das NVB wurden so geregelt, dass eine Substrattemperatur von ≤ 230 °C eingehalten wurde. Die Prozessdauer dieses Vorbehandlungsschrittes betrug 100 min.

Als nächster Prozessschritt erfolgt das Ätzen der Substratoberflächen, um die Substratoberflächen von gegebenenfalls vorliegenden Verunreinigungen zu befreien. Dafür wird das NVB zwischen der Heißkathode und einer in der Beschichtungsanlage vorgesehenen Hilfsanode betrieben. Hier kann eine DC-, eine gepulste DC- oder eine mit Wechselstrom betriebene MF- oder RF-Versorgung zwischen den Substraten und der Masse angelegt werden. Bevorzugt wurden die Werkstücke aber mit einer negativen Biasspannung beaufschlagt.

Für diesen Vorbehandlungsschritt wurden folgende Prozessparameter eingestellt:

| | |
|---|---|
| Argonfluss | 60 sccm |
| Entladestrom NVB | 150 A |
| Biasspannung | 60 V (DC) |

Unter diesen Bedingungen stellt sich ein Prozessdruck von 2,4 x 10⁻³ mbar im Beschichtungssystem ein. Die Prozessparameter wurden wieder so gewählt, dass die Substrattemperaturen von 230 °C nicht überschritten wurden. Die Dauer dieser Vorbehandlung betrug 45 min.

Im nächsten Prozessschritt erfolgt die Beschichtung des Substrates mit der CrN-Haftschicht. Dieser Prozessschritt wurde mit vier Cr-Targets durchgeführt. Bei der Anzahl der Targets werden verschiedene Aspekte berücksichtigt. Die Beschichtungsdauer kann reduziert werden, wenn die Anzahl der Targets erhöht wird, wobei dann jedoch die thermische Belastung der Substrate ansteigt. Im vorliegenden Prozess sollten bei der Beschichtung ebenfalls die 230 °C bei der Substrattemperatur nicht überschritten werden. Die Prozessparameter für die Beschichtung mit der Haftschicht waren:

| | |
|---|---|
| Stickstofffluss | geregelt auf 3 Pa Gesamtdruck |
| Strom je Cr-Target | 140 A |
| DC Substratbiasspannung | U = -20 V |

Damit konnten wiederum Substrattemperaturen unter 230 °C gewährleistet werden. Die Dauer des Prozessschrittes zur Aufbringung der Haftschicht betrug 60 min.

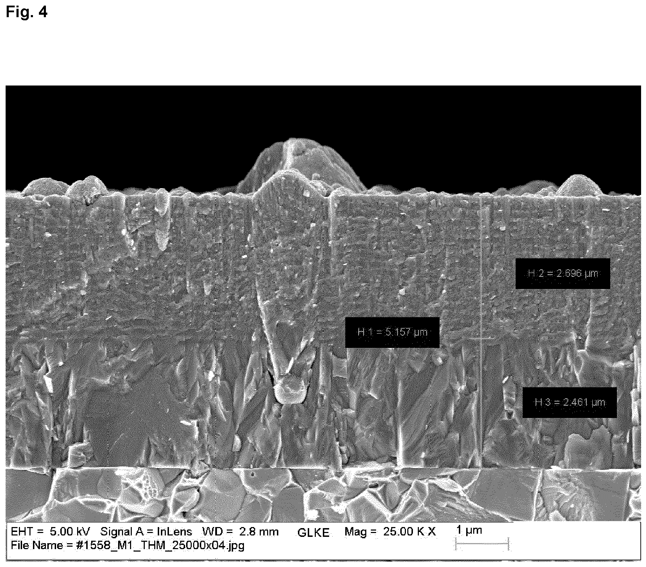

Im Anschluss an die Beschichtung der Substrate mit der Haftschicht erfolgt die Beschichtung mit der Funktionsschicht. Wie schon weiter oben beschrieben ist diese besonders einfach und wirtschaftlich im Falle CrN-CrON-Mehrlagenschicht. Die vier Cr-Targets werden weiterhin unverändert mit jeweils 140 A pro Target betrieben. Für die erste CrON-Schicht werden dann für 2 min 300 sccm Sauerstoff in das Beschichtungssystem eingelassen. Anschließend wird der Sauerstofffluss für 2 min wieder auf Null gesetzt, also ausgeschaltet. Dann erfolgt dieselbe Abfolge wie vorher beschrieben: 2 min Sauerstoffzugabe von 300 sccm, 2 min Ausschalten des Sauerstoffflusses, wobei eine CrN-Beschichtung erhalten wird. In dem vorliegenden Prozess wurde diese Abfolge 18 Mal durchgeführt, d.h. es ergaben sich insgesamt 36 Einzelschichten. Mit dem Aufbringen dieser Funktionsschicht wurde damit auch das Aufbringen der gesamten Schutzschicht abgeschlossen. Nachdem die Substrate anschließend auf etwa 150 °C abgekühlt waren, wurde das Beschichtungssystem zur Substratentnahme belüftet. Die Fig. 4 zeigt eine solche Schutzschicht, allerdings auf einem polierten Hartmetallsubstrat, das aber bei der Beschichtung der Stahlkolben unter gleichen Bedingungen mitbeschichtet wurde. Der Bruchquerschnitt wurde mit einem Rasterelektronenmikroskop bei einer Vergrößerung von 25000x aufgenommen. Die etwa 2,4 µm dicke Haftschicht auf dem Substrat, die aus CrN besteht, ist erkennbar. Ferner ist auf der Haftschicht die etwa 3,0 µm dicke Funktionsschicht aus CrN/CrON als Mehrlagenschicht erkennbar.

Im oben beschriebenen Prozess wurde die Beschichtungstemperatur auf 230 °C begrenzt. Eine solche Begrenzung kann sinnvoll sein, wenn beispielsweise die Stahlkolben spezielle Vorbehandlungen erfahren haben, die temperaturempfindlich sind. Falls die Stahlkolben aber lediglich Stahl aufweisen, der höhere Temperaturen zulässt, ist es bevorzugt, etwas höhere Temperaturen bei der Beschichtung zu wählen, da dann die Vorbehandlungsschritte effektiver werden und kleine Kavitäten im Kolben besser durch Ausgasungsprozesse gereinigt werden können. Dabei sind Substrattemperaturen zwischen 300 °C und 400 °C bevorzugt.

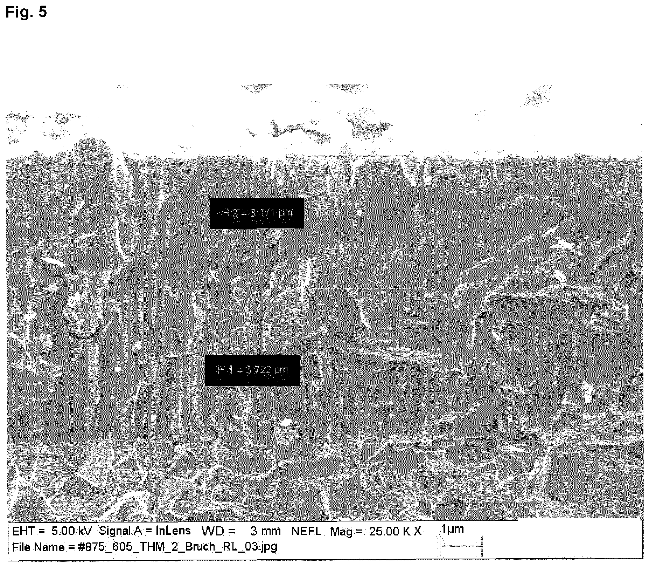

Fig. 5 zeigt in Analogie zur Fig. 4 eine Schutzschicht, die aus einer CrN-Haftschicht und einer einzelnen AICrO-Funktionsschicht gemäß der nicht erfindungsgemäßen Ausführungsform besteht. Der Schichtquerschnitt betrachtet im Rasterelektronenmikroskop (Vergrößerung 50000x) zeigt eine Gesamtschichtdicke von etwa 3 µm, bestehend aus einer 1,6 µm dicken CrN-Haftschicht und einer 1,4 µm dicken AICrO-Funktionsschicht. In diesem Falle wurde mit Cr-Targets und AICr-Targets im Beschichtungssystem gearbeitet. Die Vorbehandlungsschritte entsprachen denjenigen, die bereits weiter oben beschrieben wurden.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die in der vorliegenden Anmeldung genannten und erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Beispiel 1

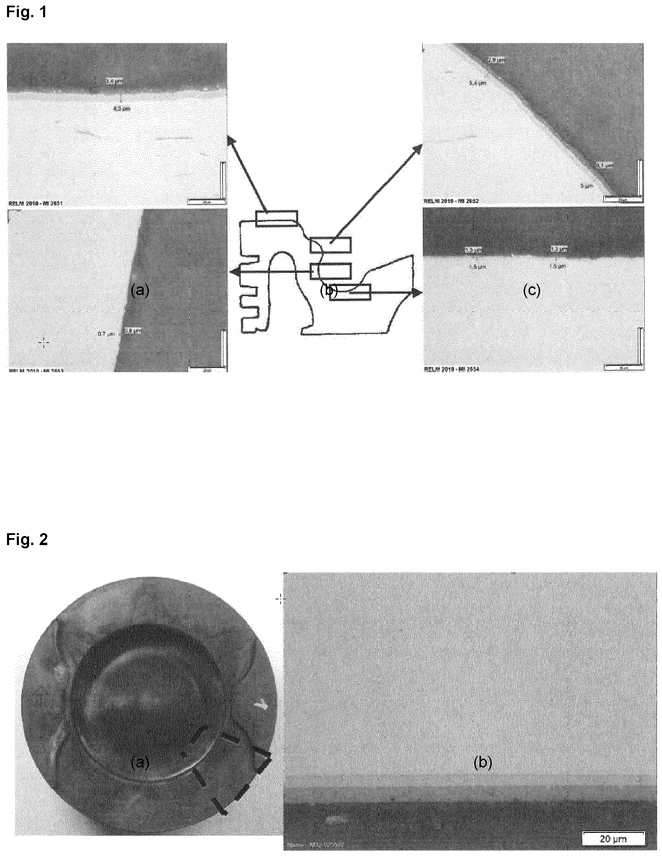

Der Muldenrand des Kolbenbodens eines Stahlkolbens wurde mit dem PVD-Verfahren, wie es vorstehend detailliert beschrieben worden ist, zunächst mit einer 3,9 µm dicken Haftschicht aus CrN und anschließend mit einer Funktionsschicht aus 23 Schichten CrN und 23 Schichten CrON, die jeweils eine Schichtdicke von etwa 0,06 µm aufwiesen und abwechselnd aufgebracht wurden, beschichtet. Die erste auf der Haftschicht aufgebrachte Schicht der Funktionsschicht war dabei eine CrN-Schicht. Die Gesamtdicke der Funktionsschicht betrug etwa 2,9 µm. Die Fig. 1 zeigt die erhaltene Beschichtung im Abscheidungszustand, wobei Fig. 1(b) einen schematischen Querschnitt durch den beschichteten Kolben zeigt und die Figuren 1(a) und 1(c) jeweils mikroskopische Schliffbilder von Schnittflächen durch den Stahlkolben gemäß Fig. 1(b) zeigen.

Der erhaltene beschichtete Stahlkolben wurde in einen Motor eingebaut und ein Testlauf wurde durchgeführt (PKW-Dieselmotor mit Stahlkolben, 150 kW Leistung, 120 Stunden Belastungstest, Temperatur am Muldenrand etwa 600 °C). Nach dem Testlauf wurde der Kolben wieder ausgebaut (vgl. Fig. 2(a)) und es wurde ein mikroskopisches Schliffbild einer Schnittfläche durch den Stahlkolben im Bereich des Muldenrands angefertigt, das in der Fig. 2(b) gezeigt ist.

Wie es aus der Fig. 2(b) ersichtlich ist, ist die auf den Muldenrand aufgebrachte Schutzschicht völlig unversehrt und das Material des Stahlkolbens weist keinerlei Zunderkerben auf. Dies zeigt, dass der erfindungsgemäße Stahlkolben eine hervorragende Widerstandsfähigkeit gegen eine Schädigung durch Oxidation aufweist.

### Vergleichsbeispiel

Mit dem Stahlkolben, wie er im Beispiel 1 verwendet worden ist, auf den jedoch keine Schutzschicht aufgebracht worden ist, wurde der gleiche Testlauf wie im Beispiel 1 durchgeführt.

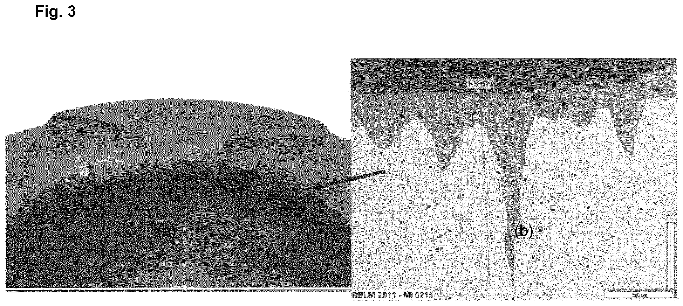

Wie es aus den Fig. 3(a) und (b) ersichtlich ist, weist das Material des unbeschichteten Stahlkolbens Zunderkerben auf, was zu den vorstehend beschriebenen Nachteilen führt.

## Patentansprüche

1. Stahlkolben für eine Brennkraftmaschine, der einen Kolbenboden und eine auf dem Kolbenboden aufgebrachte Schutzschicht aufweist, wobei die Schutzschicht enthält:
a) eine Haftschicht aus Cr oder CrN, die auf der Oberfläche des Kolbenbodens vorliegt, und
b) eine Funktionsschicht, die auf der Haftschicht vorliegt, wobei die Funktionsschicht eine oder mehrere Schicht(en) (A) aus CrN sowie eine oder mehrere Schicht(en) (B) aus CrON in der Form von [(A)/(B)]ₐ aufweist, wobei a = 1 bis 100 ist.

2. Stahlkolben für eine Brennkraftmaschine nach Anspruch 1, bei dem a = 1 ist.

3. Stahlkolben für eine Brennkraftmaschine nach Anspruch 2, wobei (A) nicht vorliegt.

4. Stahlkolben für eine Brennkraftmaschine nach Anspruch 2, bei dem die Schicht (B) als Gradientenschicht mit zunehmendem Sauerstoffanteil in der Richtung der Oberfläche vorliegt, die der Schicht (A) abgewandt ist.

5. Stahlkolben für eine Brennkraftmaschine nach Anspruch 1, bei dem a = 2 bis 100 ist.

6. Stahlkolben für eine Brennkraftmaschine nach einem der Ansprüche 1 bis 5, bei dem die Schutzschicht eine Dicke von 1 µm bis 15 µm aufweist.

7. Stahlkolben für eine Brennkraftmaschine nach einem der Ansprüche 1 bis 6, bei dem die Haftschicht eine Dicke von 0,5 µm bis 5 µm aufweist.

8. Stahlkolben für eine Brennkraftmaschine nach einem der Ansprüche 1 bis 7, bei dem die Funktionsschicht eine Dicke von 0,5 µm bis 10 µm aufweist.

9. Stahlkolben für eine Brennkraftmaschine nach einem der Ansprüche 1 bis 8, bei dem die Schichten (A) und (B) oder (C) und (C') unabhängig jeweils eine Dicke von 0,04 µm bis 0,25 µm aufweisen.

10. Stahlkolben für eine Brennkraftmaschine nach einem der Ansprüche 1 bis 9, bei dem die Schichten (A) und (B) oder (C) und (C') jeweils die gleiche Dicke aufweisen.

11. Stahlkolben für eine Brennkraftmaschine nach einem der Ansprüche 1 bis 10, bei dem die Schutzschicht nur auf dem Muldenrand des Kolbenbodens vorliegt.

12. Verfahren zur Herstellung eines Stahlkolbens für eine Brennkraftmaschine nach einem der Ansprüche 1 bis 11, das die Schritte aufweist:
Bereitstellen eines Stahlkolbens, der einen Kolbenboden aufweist, und
Aufbringen einer Schutzschicht, wie sie in einem der Ansprüche 1 bis 15 definiert ist, auf den Kolbenboden, insbesondere nur auf den Muldenrand des Kolbenbodens, mittels eines PVD-Verfahrens.

13. Verfahren nach Anspruch 12, bei dem die Beschichtungstemperatur in dem PVD-Verfahren 150 °C bis 550 °C beträgt.

## Claims

1. Steel piston for an internal combustion engine having a piston head and a protective layer applied to the piston head, wherein the protective coating comprises:
a) a bonding coating of Cr or CrN, which is present on the surface of the piston head, and
b) function coating, which is present on the bonding coating, wherein the function coating comprises one or several coatings (A) of CrN and one or several CrON coatings (B) in the form of [(A)/(B)]ₐ, where a = 1 to 100.

2. Steel piston for an internal combustion engine according to claim 1, wherein a = 1.

3. Steel piston for an internal combustion engine according to claim 2, wherein (A) is absent.

4. Steel piston for an internal combustion engine according to claim 2, in which the coating (B) is present as a gradient coating with increasing oxygen content in the direction of the surface facing away from the coating (A).

5. Steel piston for an internal combustion engine according to claim 1, in which a = 2 to 100.

6. Steel piston for an internal combustion engine according to one of claims 1 to 5, in which the protective coating has a thickness of 1 µm to 15 µm.

7. Steel piston for an internal combustion engine according to one of claims 1 to 6, in which the bonding coating has a thickness of 0.5 µm to 5 µm.

8. Steel piston for an internal combustion engine according to one of claims 1 to 7, in which the function coating has a thickness of 0.5 µm to 10 µm.

9. Steel piston for an internal combustion engine according to one of claims 1 to 8, in which the coatings (A) and (B) or (C) and (C') independently respectively have a thickness of 0.04 µm to 0.25 µm.

10. Steel piston for an internal combustion engine according to one of claims 1 to 9, in which the coatings (A) and (B) or (C) and (C') respectively have the same thickness.

11. Steel piston for an internal combustion engine according to one of claims 1 to 10, in which the protective coating is present only on the trough edge of the piston head.

12. Method of manufacturing a steel piston for an internal combustion engine according to one of claims 1 to 11, comprising the steps of:
providing a steel piston having a piston head, and
applying a protective coating as defined in one of claims 1 to 15, on the piston head, in particular only on the trough edge of the piston head, by means of a PVD process.

13. Method according to claim 12, in which the coating temperature in the PVD process is 150 °C to 550 °C.

## Revendications

1. Piston en acier pour moteur à combustion interne, qui comprend une tête de piston et une couche de protection appliquée sur la tête de piston, dans lequel la couche de protection contient :
a) une couche adhésive de Cr ou de CrN, qui est présente sur la surface supérieure de la tête de piston, et
b) une couche fonctionnelle, qui est présente sur la couche adhésive, dans lequel la couche fonctionnelle comprend une ou plusieurs couche(s) (A) de CrN et une ou plusieurs couche(s) (B) de CrON sous la forme de [(A)/(B)]ₐ, où a = 1 à 100.

2. Piston en acier pour un moteur à combustion interne selon la revendication 1, dans lequel a = 1.

3. Piston en acier pour un moteur à combustion interne selon la revendication 2, dans lequel (A) n'est pas présente.

4. Piston en acier pour un moteur à combustion interne selon la revendication 2, dans lequel la couche (B) est présente sous la forme d'une couche à gradient avec une teneur en oxygène croissante dans la direction de la surface supérieure, qui est opposée à la couche (A).

5. Piston en acier pour un moteur à combustion interne selon la revendication 1, dans lequel a = 2 à 100.

6. Piston en acier pour moteur à combustion interne selon l'une quelconque des revendications 1 à 5, dans lequel la couche de protection présente une épaisseur de 1 µm à 15 µm.

7. Piston en acier pour moteur à combustion interne selon l'une quelconque des revendications 1 à 6, dans lequel la couche adhésive présente une épaisseur de 0,5 µm à 5 µm.

8. Piston en acier pour moteur à combustion interne selon l'une quelconque des revendications 1 à 7, dans lequel la couche fonctionnelle présente une épaisseur de 0,5 µm à 10 µm.

9. Piston en acier pour un moteur à combustion interne selon l'une quelconque des revendications 1 à 8, dans lequel les couches (A) et (B) ou (C) et (C') présentent chacune indépendamment une épaisseur de 0,04 µm à 0,25 µm.

10. Piston en acier pour un moteur à combustion interne selon l'une quelconque des revendications 1 à 9, dans lequel les couches (A) et (B) ou (C) et (C') présentent chacune la même épaisseur.

11. Piston en acier pour un moteur à combustion interne selon l'une quelconque des revendications 1 à 10, dans lequel la couche de protection est présente uniquement sur le bord de rainure de la tête du piston.

12. Procédé de fabrication d'un piston en acier pour un moteur à combustion interne selon l'une quelconque des revendications 1 à 11, comprenant les étapes consistant à :
fournir un piston en acier, qui comprend une tête de piston, et
appliquer une couche de protection, telle que définie dans l'une quelconque des revendications 1 à 15, sur la tête du piston, en particulier uniquement sur le bord de rainure de la tête du piston, au moyen d'un procédé-PVD.

13. Procédé selon la revendication 12, dans lequel la température de revêtement dans le procédé PVD est de 150°C à 550°C.
